(19) Europäisches Patentamt
European Patent Office
Office européen des brevets

(11) Publication number: **0 296 257**
**A1**

(12) # EUROPEAN PATENT APPLICATION

(21) Application number: 87108880.3

(22) Date of filing: 22.06.87

(51) Int. Cl.4: C30B 25/02, C30B 29/40, C23C 16/40, H01L 21/316, H01L 21/205

(43) Date of publication of application: 28.12.88 Bulletin 88/52

(84) Designated Contracting States: AT BE CH DE ES FR GB GR IT LI LU NL SE

(71) Applicant: AMERICAN CYANAMID COMPANY
1937 West Main Street P.O. Box 60
Stamford Connecticut 06904-0060(US)

(72) Inventor: Valentine., Donald Jr.
20 Blue Ridge
Ridgefield Connecticut 06877(US)
Inventor: Brown, Duncan William
30 Cobblestone Place
Wilton Connecticut 06897(US)

(74) Representative: Wächtershäuser, Günter, Dr.
Tal 29
D-8000 München 2(DE)

(54) **Branched monoalkyl group V A compounds as MOCVD element sources.**

(57) A process to produce one or more Group III A-V A element epitaxial layers over a crystalline substrate by reacting Group III A metalorganic vapors and a Group V A compound vapors on a heated substrate to form the epitaxial layers. These do not combine to form stable parasitic adducts if, as the Group V A compound vapor source, there is used a branched monoalkyl Group V A compound, the alkyl groups containing from about 3 to about 10 carbon atoms. In an embodiment, a phosphosilicate or an arsenosilicate glass is deposited on a semiconductor substrate when branched monoalkyl Group V A compounds are vaporized and reacted with sources of silicon and oxygen on the heated substrate.

EP 0 296 257 A1

# BRANCHED MONOALKYL GROUP V A COMPOUNDS AS MOCVD ELEMENT SOURCES

This invention relates to epitaxial growth techniques, and more particularly, to epitaxial growth of Group III A-V A element semiconductor materials by metal-organic chemical vapor deposition (MOCVD). In an embodiment, the invention also provides for depositing glossy (non-crystalline) films on semiconductor substrates.

## BACKGROUND OF THE INVENTION

The increasing importance of compound semiconductors of Group III A-V A elements for a variety of optoelectronic applications such as light-emitting diodes, solid state lasers and photodetectors is well known. A most useful process for the production of such materials is the vapor phase deposition of monocrystalline films on a heated substrate. This process known as MOCVD (metalorganic chemical vapor deposition) has been used successfully for the growth of epitaxial layers of compounds of Group III A-V A elements such as indium phosphide, gallium arsenide, gallium phosphide, gallium aluminum arsenide on a variety of substrates.

In Philbrick et al., U.S. 3,925,119, Born et al., U.S. 3,947,549 and Jolly, U.S. 4,253,887, are disclosed several methods for the vapor phase preparation of such compounds including the reaction of a Group III A metal halide with a Group V A elemental hydride.

In Duchemin et al, U.S. 4,220,488 and Manasevit, U.S. 4,404,265, the reaction of a Group III A trialkyl organometallic compound with a Group V A hydride is disclosed. The latter method had been particularly useful in the preparation of high purity Group III A-V A element epitaxial layers. However, the Group V A gaseous hydrides, particularly arsine and phosphine, pose several problems. These gases often contain high concentrations of oxygen, which is detrimental in MOCVD processes, and they require extreme safety measures during use due to their toxicity, dangers posed by fire hazard, and the necessity for storage in high pressure cylinders. In addition, serious difficulties are encountered in certain cases such as in the preparation of indium phosphide due to a parasitic reaction between trialkyl indium such as triethylindium and phosphine which results in the formation of a stable, non-volatile, polymeric product. This material does not decompose under the normal vapor phase epitaxy conditions to give indium phosphide and instead deposits on the walls of the reactor apparatus. The above-mentioned U.S. 4,220,488 deals with one attempt to overcome this unwanted parasitic reaction, in which phosphine is pre-pyrolyzed at the extremely high temperature of 700-1000 °C and the preformed phosphorus vapor is reacted in a second chamber with triethyl indium to form indium phosphide. In another attempt, Moss et al., U.S. 4,436,769, the trialkyl indium is first reacted at low temperatures with either a trialkyl phosphine or trialkyl amine to form a volatile intermediate which is then treated on the heated substrate with gaseous phosphine to form indium phosphide. Although such modifications overcome the formation of the undesirable, side reaction product, more complex processes are needed due to the additional reaction steps involved, and the use of gaseous phosphine is still required.

In Ichiki et al., U.S. 3,867,202, it is suggested to use instead of phosphine or arsine a variety of mono-, di-, and trialkyl compounds of the respective phosphines and arsines. This patent teaches the use of $C_1$, $C_2$ and $C_3$ alkyl compounds but it does not specify the use of any branched alkyl compounds. Ichiki et al. rather, imply a preference for trialkyl compounds by using such in all of their examples. It has now, unexpectedly been found that monoalkyl substituted Group V A compounds function very well and moreover, branched monalkyl Group V A compounds function extremely well. Furthermore, using alkyl groups having more than three carbon atoms has been found to be especially preferable in the sense that these eliminate the need to use Ichiki et al.'s preferred triethylphosphine. This latter compound is known to form stable addition complexes with trialkyl Group III A compounds, e.g., trialkylindium compounds. Such complexes require higher thermal decomposition temperatures, and these do not lead to smooth mirror-like layers.

It is, accordingly, a principal object of the present invention to provide an improved process to deposit Group III A-V A element epitaxial layers.

It is a further object of the invention to deposit such epitaxial layers under conditions which are not extremely hazardous.

It is still another object to provide a method of depositing Group III A-V A element epitaxial films on substrates at moderate temperatures in the form of mirror-like layers.

Yet another object is to grow epitaxial layers of Group III A-V A metals without any accompanying deleterious reactions.

A further object is to provide a method of depositing glossy (non crystalline) films on semiconductor substrates.

## SUMMARY OF THE INVENTION

The foregoing objects and advantages are accomplished in accordance with this invention, by growing high purity Group III A-V A film layers on semiconductor substrates through vapor phase deposition by use of branched monoalkyl Group V element compounds as sources. The invention is based on the unexpected finding that by use of the said branched monoalkyl compounds, e.g., phosphines and arsines, a variety of Group III A-V A elemental epitaxial films are produced by chemical vapor phase deposition (MOCVD) at substrate temperatures in the range of from about 250°C to about 650°C, but especially at temperatures in the range of from about 550°C to about 650°C, and most preferably in the range of from about 610°C. to about 630°C. Epitaxial films prepared by the method of this invention compare favorably in quality to the material that is obtained using Group V A elemental hydrides, for example, phosphine or arsine, while at the same time eliminating the handling problems and fire and toxicity dangers posed by these gases. In another aspect of the invention , mirrorlike (non-crystalline) films comprising phosphosilicate glasses and arsenosilicate glasses are deposited on semiconductor substrates through the use of vaporizable branched monoalkyl phosphines, or arsines, and a source of silicon, e.g., a silane, and a source of oxygen.

## DETAILED DESCRIPTION OF THE INVENTION

The novel method for the growth of Group III A-V A epitaxial layers involves the vapor phase reaction of an alkyl derivative of a Group III A element with a branched monoalkyl derivative of a Group V A element at the surface of a heated substrate. In a preferred embodiment of the process, vapors of the above reactants, admixed with a carrier gas, typically hydrogen, are introduced into a reactor chamber, combined, and allowed to impinge upon the substrate. The reaction to form the epitaxial layers occurs on the surface of the substrate which rests on a graphite susceptor heated with an RF induction heater. Any suitable apparatus, well known to those skilled in this art can be used. Detailed descriptions of suitable apparatus may be found in J. Electrochem. Soc. Solid State Science Vol. 116, 1725 (1969) and in the abovementioned U.S. 4,436,769.

Branched monoalkyl derivatives of phosphine and arsine are liquids, at room temperature and are easier and safer to handle than gaseous phosphine and arsine. They react cleanly with Group III A trialkyl derivatives under normal vapor phase epitaxy conditions to form the corresponding phosphides and arsenides. This clean reaction at normal temperature is of particular importance in the preparation of . indium phosphide since the use of branched monoalkyl phosphines avoids the formation of the undesirable, non-volatile, polymeric side reaction product encountered with gaseous phosphine and trialkylindium while at the same time eliminating the high temperature pyrolysis needed to decompose the more stable trialkylphosphine derivatives.

Suitable branched monoalkyl derivatives of phosphine and arsine for this invention are liquids which are thermally stable at or around room temperature and which provide sufficient vapor concentration to interact with the Group III A metal alkyl derivatives in the vapor phase. Preferably, they decompose at sufficiently high temperatures (above 250°C) to avoid unwanted addition products but still at sufficiently low temperatures (550-650°C) to allow the reaction of the in-situ generated phosphine or arsine to proceed under optimum conditions. Examples of Group V A branched monoalkyl derivatives useful in this invention include monoisopropylphosphine, monoisobutylphosphine, monotertiarybutylphosphine, monoisoamylphosphine, monotertiaryamylphosphine, monoisopropylarsine, monoisobutylarsine, monotertiarybutylarsine, monoisoamylarsine, monotertiaryamylarsine and the like. Preferred compounds are monoisobutylphosphine, monotertiarybutylphosphine, monoisobutylarsine and monotertiarybutylarsine.

In accordance with the method of this invention, the trialkyl derivatives of Group III A elements are compounds which are normally thermally stable at or around room temperature and which provide sufficient vapor concentration to interact with the above branched monoalkylphosphines by vapor phase epitaxy at the surface of the heated substrate. Examples of Group III A alkyl derivatives include but are not limited to trimethylgallium, triethylgallium, trimethylindium, triethylindium, trimethylaluminum, triethylaluminum, triisobutylaluminum and the like.

The branched monoalkylphosphines of this invention may be prepared by the reaction of phosphine and appropriate olefins using as catalysts either free-radical initiators or acids. In the reaction catalyzed by free-radical initiators, a branched terminal olefin such as 2-methylpropene generally results in the formation of a terminally substituted branched monoalkylphosphine.

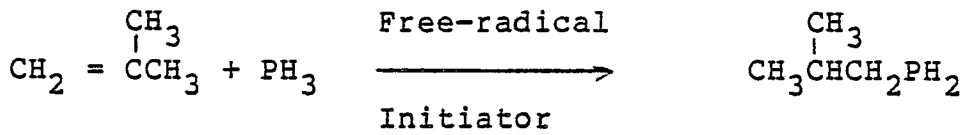


Similarly substituted monoalkylphosphines are prepared from 2-methyl-1-butene, 2-methyl-1-pentene, 2-ethyl-1-pentene and the like. The reaction is carried out in the presence of a high molar excess of phosphine to avoid formation of di-substituted and tri-substituted alkylphosphines. Free radical initiators that may be used for the above reaction include but are not limited to azobisisobutyronitrile, azobis (alpha-methylbutyronitrile), 2-(tertiarybutylazo)isobutyronitrile, azocumene and the like. A more detailed discussion of the conditions and catalyst usage required for the preparation of monoalkylphosphines is found in Rauhut et al., Journal of Organic Chem. 26 5138 (1961). In the acid catalyzed reaction, which is also known, phosphine is reacted with a branched olefin for example, isobutylene, to give a monoalkylphosphine substituted on a tertiary carbon atom, as for example, monotertiarybutylphosphine, as disclosed in H. C. Brown, U.S. 2,584,112.

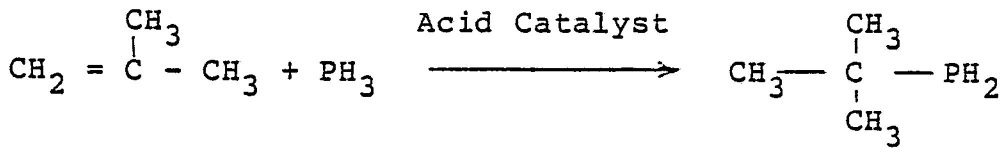


The reaction is carried out in the presence or absence of solvent, and high molar excess phosphine. The acid catalyst may be sulfuric acid, methanesulfonic acid, ethanesulfonic acid, toluenesulfonic acid and the like. Purification of the above branched monoalkylphosphines is conveniently accomplished by fractional distillation.

The branched alkylarsines of this invention may be prepared by a well known route involving the reaction of the corresponding branched alkyl arsenic dichloride and lithium aluminum hydride, Tzschach et al, Z. Inorg. Allg. Chem. 336, 36 (1965). The intermediates, branched alkyl arsenic dichlorides, are in turn prepared by the well known reaction of the corresponding branched alkyl magnesium chloride and arsenic trichloride.

A variety of semiconductor epitaxial layers of Group III A-V A elements may be produced by the method of this invention, including but not limited to indium phosphide, gallium phosphide, gallium arsenide, gallium indium arsenide, aluminum gallium arsenide, gallium arsenide phosphide, gallium indium arsenide phosphide, mixtures and combinations of any of the foregoing, and the like. Devices prepared from these semiconductor materials include lightemitting diodes, injection lasers, photodetectors, microwave diodes and the like.

In addition to their use as phosphorus and arsenic sources for the growth of epitaxial films on semiconductor substrates, branched monoalkyl phosphines and arsines are also useful as phosphorus and arsenic sources in the deposit of phosphosilicate and arsenosilicate glasses on semiconductor substrates using a chemical vapor deposition (CVD) process. Phosphosilicate and arsenosilicate glasses, formed as films on semiconductor devices, are used as protective (passivating) coatings on the surface of substrates such as silicon or germanium, and may be applied before or after metallization. These composites are described by W.A.

Pliskin et al., in Handbook on Semiconductors, Volume 3, Chapter 11, Passivation and Insulation, pages 641-687 (1980), and references tehrein. As is known in the art, e.g., Miyamoto, U.S. 4,513,026, phosphosilicate glass films are most conveniently deposited on a substrate in a conventional CVD type reactor from a reaction gas mixture of silane, phosphine and oxygen. The use of liquid branched monoalkyl phosphines or arsines, as a phosphorus or arsenic source, minimizes the handling and safety related problems associated with the use of gaseous phosphine, and arsine and provides a more efficient delivery of phosphorus or arsenic. The deposition of phosphosilicate glasses or arsenosilicate on silicon wafers

generally occurs at 300-500 °C, preferably at 350-450 °C, using a molar ratio of branched monoalkylphosphine, preferably monoisobutylphosphine or monotertiarybutylphosphine, to silane of 0.03 to 0.15, preferably 0..05 to 0.10. Optionally, a carrier gas such as nitrogen may be used with the above mixture of gases and vaporized branched monoalkyl phosphine.

Branched monoalkyl arsines such as monotertiarybutylarsine may also be used in the formation of arsenosilicate glasses thus minimizing safety problems associated with the use of arsine gas.

## DESCRIPTION OF THE PREFERRED EMBODIMENTS

The following Examples illustrate the process and the composites obtained by the practice of this invention. They are not to be construed as limiting the claims in any manner whatsoever.

## EXAMPLE 1

The apparatus for the growth of Group III A-V A epitaxial layers is described in Journal of Electronic Materials 10 (6) 1051 (1981) and in U.S. 4,436,769.

Cool vapors of monoisobutylphosphine (IBP) 10 °C, (vapor pressure of 57 mm Hg) and trimethyl indium (TMIn) (17 °C, vapor pressure 1 mmm Hg) with hydrogen as carrier gas are introduced into a horizontal cold-wall reactor and mixed at IBP/TMIn ratio of 140. The mixed vapor streams impinge upon an indium phosphide (InP) substrate which rests on a graphite susceptor heated to 610 °C by an RF induction coil surrounding the reaction vessel. Under these conditions the indium phosphide growth efficiency was $6X10^3$ m/mole indium which is comparable to that obtained with phosphine itself. The indium phosphide epitaxial layers have smooth mirrorlike appearance. Hall effect studies show that the sample of InP is n-type with a carrier concentration of $2.5 \times 10^{16}$ $cm^{-3}$ and mobility of 2800 $cm^2$/V-sec.

## EXAMPLE 2

The procedure of Example 1 is followed and similar indium phosphide epitaxial layers are grown on indium phosphide substrate by substituting tertiarybutylphosphine for isobutylphosphine above.

## EXAMPLE 3

Using the procedure in Example 1, but substituting respectively for monoisobutylphosphine and trimethylindium, a mixture of monotertiarybutylarsine and trimethyl gallium, epitaxial films of gallium arsenide are grown on gallium arsenide substrate at 550 ° -650 ° C.

## EXAMPLES 4-6

Using the procedure of Example 1, but substituting respectively for the monoisobutylphosphine and trimethylindium, a mixture of monoisobutylarsine, trimethylgallium and trimethylaluminum, epilaxial films of GaAs, AlAs, and AlGaAs are grown on an indium phosphide substrate at 550 °C-650 °C.

## EXAMPLE 7

Using the procedure of Example 1, but substituting gallium phosphide or gallium arsenide in place of the indium phosphide substrate, epitaxial layers of indium phosphide are grown on gallium phosphide or gallium arsenide sub strates at 580 °C to 630 °C.

EXAMPLE 8

An epitaxial composite in the form of a superlattice is prepared by depositing a first layer of indium phosphide by the procedure of Example 1 on an indium phosphide substrate, then directing a flow of vaporizable and decomposable trimethylgallium compound and monoisobutylphosphine or monotertiary butylphosphine against the substrate having an epitaxial layer of indium phosphide until an epitaxial layer of gallium phosphide is deposited thereon, and then repeating the alternating deposition until ten layers are deposited. The procedure can be repeated a number of times even up to one hundred or more times. Each layer in the superlattice will preferably have a thickness in the range of 40 to 250 Angstroms, and the ultimate thickness of the combined layers can range up to several, e.g., 3-4 microns. The procedure can be further modified by producing one or more of a third chemically distinct layer by directing combined flows of a vaporizable trimethylgallium and monoisobutylphosphine or monotertiarybutylphosphine against the substrate. Upon repetition, the product will be an epitaxial composite of the superlattice type wherein the epitaxial layers are randomly, depending on the order of introduction of reactants, indium phosphide or gallium phosphide and indium gallium phosphide.

EXAMPLE 9

Using the procedure in Example 8 an epitaxial composite in the form of a superlattice is prepared by depositing on a gallium arsenide substrate, epitaxial layers of gallium arsenide, and gallium aluminum arsenide. The epitaxial layers are formed by directing to the substrate combined flows of vaporizable trimethylgallium, monotertiarybutylarsine for GaAs and trimethyl gallium, monotertiarybutylarsine and triethylaluminum for GaAlAs.

EXAMPLE 10

Vapors of monotertiarybutylphosphine, silane and oxygen, using nitrogen as a carrier gas, are introduced in a CVD reactor of the type disclosed in Miyamoto, U.S. 4,513,026. A molar ratio of monotertiarybutylphosphine to silane of 0.08 is used. The mixed vapors impinge upon a silicon wafer substrate at 400-450 °C to form a phosphosilicate glass.

The above-mentioned patents and publications are incorporated herein by reference.

Many variations of this invention will suggest themselves to those skilled in this art in light of the above detailed description. For example, instead of hydrogen or nitrogen as a carrier gas, helium and argon can be used. Instead of monoisobutylphosphine or monotertiarybutylphosphine, monoisopropylphosphine, monoisoamylphosphine, monotertiaryamylphosphine, monoisopropylarsine, monoisobutylarsine, monotertiarybutylarsine, monoisoamylarsine, monotertiaryamylarsine can be used. The susceptor can be heated to any temperature in the range of 250 °C to 650 °C, e.g., 550 °C to 300 °C, most preferably 610 °C to 630 °C for vapor phase epitaxy and 400-450 °C for glass layer deposition. The carrier gas can be omitted. An inverted vertical MOCVD reactor can be used, as may any other reactor configuration, all of them being well known to those skilled in the art. All such obvious variations are within the full intended scope of the appended claims.

## Claims

1. A method for growing a Group III A-V A element epitaxial layer over a crystalline substrate or over a surface of a crystalline substrate having one or more epitaxial layers, said method comprising the steps of:

(i) heating said substrate to a predetermined temperature;

(ii) contacting a surface of the heated substrate with at least one vaporized Group III A metalorganic compound and with at least one vaporized Group V A compound of the formula

$R - Y - H_2$

wherein Y is P or As and R is branched alkyl of from about 3 to about 10 carbon atoms; and

(iv) reacting the vaporized compounds at the heated substrate surface to form said epitaxial layer on said surface.

2. A method as defined in Claim 1 wherein, in the Group V A compound, R comprises from about 4 to about 6 carbon atoms.

3. A method as defined in Claim 1 wherein said Group V A compound is selected from monoisopropylphosphine, monoisobutylphosphine, monotertiarybutylphosphine, monoisoamylphosphine, monotertiaryamylphosphine, monoisopropylarsine, monoisobutylarsine, monotertiarybutylarsine, monoisoamylarsine, monotertiaryamylarsine, or a mixture of any of the foregoing.

4. A method as defined in Claim 3 wherein said Group V A compound is selected from monoisobutylphosphine, monotertiarybutylphosphine, monoisobutylarsine and monotertiarybutylarsine, or a mixture of any of the foregoing.

5. A method as defined in Claim 4 wherein said Group V A compound is monoisobutylphosphine or monotertiarybutylphosphine.

6. A method as defined in Claim 4 wherein said Group V A compound is montertiarybutylarsine.

7. A method as defined in Claim 1 wherein said Group III A metalorganic is a trialkylindium, a trialkylgallium or a trialkylaluminum, or a mixture of any of the foregoing, said alkyl groups having from about 1 to about 6 carbon atoms.

8. A method as defined in Claim 1 wherein the substrate is heated to a temperature in the range of from about 250° to about 660° C.

9. A method as defined in Claim 8 wherein the vaporized Group III A metalorganic and Group V A compound are directed toward the substrate as flows and at least one of said directed flows further comprises a flow of a carrier gas.

10. A method as defined in Claim 9 wherein said carrier gas comprises hydrogen.

11. A method for the deposition of a phosphosilicate or an arsenosilicate glass on a semiconductor substrate, said method comprising the steps of:

(i) heating said substrate to a predetermined temperature;

(ii) contacting a surface of the heated substrate with at least one source of silicon, a source of oxygen and at least one vaporized Group V A compound of the formula

$R - Y - H_2$

wherein Y is P or As and R is branched alkyl of from about 3 to about 10 carbon atoms; and

(iii) reacting the sources of silicon and oxygen and the Group V A compound at the heated substrate to form said glass on said surface.

12. A method as defined in Claim 11 wherein the Group V A compound is monotertiarybutylphosphine.

13. A method as defined in Claim 11 wherein the V A compound is monotertiarybutyl arsine.

European Patent Office

# EUROPEAN SEARCH REPORT

Application Number

EP 87 10 8880

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | JOURNAL OF CRYSTAL GROWTH, vol. 77, nos. 1-3, September 1986, pages 11-18, Elsevier Science Publishers B.V., Amsterdam, NL; C.H. CHEN et al.: "MOVPE growth of InP using isobutylphosphine and tert-butylphosphine" * Pages 12-13 * | 1-5,7-10 | C 30 B 25/02<br>C 30 B 29/40<br>C 23 C 16/40<br>H 01 L 21/316<br>H 01 L 21/205 |
| Y | Idem<br>--- | 6 | |
| Y | DE-A-2 411 603 (SUMITOMO CHEMICAL CO. LTD) * Claims 1,10 * & US-A-3 867 202 (Cat. D)<br>--- | 6 | |
| A | EP-A-0 141 496 (MORTON THIOKOL INC.) * Claim 1 *<br>--- | 11-13 | |
| A | JOURNAL OF CRYSTAL GROWTH, vol. 55, no. 1, October 1981, pages 125-128, North Holland Publishing Co., Amsterdam, NL; A. TROMSON-CARLI et al.: "Evaluation of triisobutylaluminium for the epitaxial growth of AlSb compared to trimethylaluminium"<br>----- | | TECHNICAL FIELDS SEARCHED (Int. Cl.4)<br>C 23 C<br>C 30 B<br>H 01 L |

The present search report has been drawn up for all claims

| Place of search | Date of completion of the search | Examiner |
|---|---|---|
| THE HAGUE | 10-02-1988 | COOK S.D. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)